# EUROPEAN PATENT APPLICATION

(11) **EP 4 528 816 A1**
(43) Date of publication of application: **26.03.2025**
(21) Application number: 24201044.5
(22) Date of filing: 18.09.2024
(51) Int. Cl.: H01L 25/065, H01L 23/498, H01L 23/538

(54) **INTEGRATED CIRCUIT CHIPS AND PACKAGES WITH ON-CHIP TOP METAL PAD PITCH ADJUSTMENT**

(30) Priority: 19.09.2023 US 202363539327 P; 23.07.2024 US 202418781998
(71) Applicant: Tenstorrent Inc., Toronto, Ontario M3C 3E5 (CA)
(72) Inventor: NABOVATI, Aydin, Toronto (CA); PFEIFFENBERGER, Alexander Helmut, Toronto (CA); BAILEY, Daniel William, Rollingwood (US)
(74) Representative: Haseltine Lake Kempner LLP

(57) **Abstract**

Methods, systems, and apparatuses for a package with top metal pad pitch adjustment are described. A first portion of an integrated circuit (e.g., including transistors and other devices) may have a first pitch associated with internal connections. The first pitch may not align with the pitch of a desired external connection. Accordingly, a set of masks may be used to add a second portion of an integrated circuit (e.g., metal wiring) to the integrated circuit such that the integrated circuit obtains a second pitch, different than the first pitch. The first portion of the integrated circuit may be consistent across one or more integrated circuits while the second portion of the integrated circuit may be customizable for the desired external connections associated with that integrated circuit.

## Description

### CROSS REFERENCE TO RELATED APPLICATIONS

This application claims the benefit of U.S. Prov. Pat. App. No. 63/539,327, filed September 19, 2023, which is incorporated by reference herein in its entirety for all purposes.

### BACKGROUND

Chips must meet certain spacings requirements between their external contacts so that the chip may be compatible with external systems such as the connections on a printed circuit board on which the chip will be attached. In a typical system, chip's external contacts have spacings that are too small for the external systems to which it will be attached; and therefore, a substrate is placed between the chip's external contacts and the external system. A substrate has one set of contacts that are compatible with the chip, another set of contacts that are compatible with the external system, and a set of wires that connect the two sets of contacts.

In situations in which a chip's external contacts have spacings that are too small for the substrate to which it will be attached, an intermediate system such as an interposer can be introduced which has one set of contacts that are compatible with the chip, another set of contacts that are compatible with the substrate, and a set of wires that connect the two sets of contacts.

Chiplets are small integrated circuits with packages that can have finer pitches than the packages for more traditional chips. The fine pitch of the chiplets means that they will often require interposers, in addition to a substrate, to interface with other external systems. This increases the complexity of some packaging and assembly configurations and may lead to yield issues.

### SUMMARY

This disclosure relates to integrated circuit chips and packages with on-chip top metal pad pitch adjustments. Associated methods are disclosed. The top metal pad pitch adjustments may be formed by top metal wiring in an integrated circuit which routes internal connections to external chip connections. The internal connections may be pads in the metal layers of the integrated circuit. The external chip connections may be pads, solder balls, bumps, pillars, leads, or other conductive connections. The internal connections may have a finer pitch than the external chip connections. The top metal wiring in the integrated circuit may vary from one production run of the chip to the next production run. The variation in the top metal wiring may impact the connections between the internal and external connections such that the same chip may be connected to a package substrate or interposer with different pitches. For example, one variation may connect each internal connection to an external connection with a first pitch while a second variation connects every other internal connection to an external connection with a pitch that is twice as wide. The top metal wiring may be defined by different sets of masks where different sets are selected as part of different production runs of the back end of line processing for the integrated circuit. The top metal wiring may be variant across a single integrated circuit. To continue the example above, another variation could connect each internal connection on one side of the chip to an external connection with the first pitch while all other sides of the chip connected to external connections with the pitch that is twice as wide.

A method of packaging an integrated circuit is disclosed. The method comprises: forming a set of devices of the integrated circuit; forming a set of internal connections of the integrated circuit that are coupled to the set of devices of the integrated circuit; selecting a set of masks from a library of sets of masks; forming a set of metal wiring layers of the integrated circuit using the set of masks; and coupling a set of external connections of the integrated circuit to the set of internal connections via the metal wiring layers; wherein: (i) the sets of masks in the library of sets of masks are configured to form different sets of metal wiring layers; and (ii) the different sets of metal wiring layers differ in how they connect the internal connections of the integrated circuit to the external connections of the integrated circuit.

An integrated circuit is disclosed. The integrated circuit comprises: a set of devices; a set of internal connections that are coupled to the set of devices and that have a first pitch, wherein the set of internal connections are a set of metal layer pads; a set of external connections that are coupled to the set of internal connections and that have a second pitch; and a set of metal wiring layers of the integrated circuit that couple the set of internal connections to the set of external connections; wherein a subset of the set of internal connections are not connected to the set of external connections.

A method is disclosed. The method comprises: forming a first set of devices of a first integrated circuit; forming a first set of internal connections of the first integrated circuit that are coupled to the first set of devices of the first integrated circuit; selecting a first set of masks from a library of sets of masks based at least in part on a first set of external connections; forming a first set of metal wiring layers of the first integrated circuit using the first set of masks; forming a second set of devices of a second integrated circuit, wherein the second set of devices is in a same configuration as a configuration of the first set of devices; forming a second set of internal connections of the second integrated circuit that are coupled to the second set of devices of the second integrated circuit; selecting a second set of masks from the library of sets of masks based at least in part on a second set of external connections, wherein the second set of masks is different than the first set of masks and the second set of external connections has a different configuration than a configuration of the first set of external connections; and forming a second set of metal wiring layers of the second integrated circuit using the second set of masks, wherein the second integrated circuit has a configuration that is different than a configuration of the first set of metal wiring layers.

### BRIEF DESCRIPTION OF THE DRAWINGS

The accompanying drawings illustrate various embodiments of systems, methods, and various other aspects of the disclosure. A person with ordinary skills in the art will appreciate that the illustrated element boundaries (e.g., boxes, groups of boxes, or other shapes) in the figures represent one example of the boundaries. It may be that in some examples one element may be designed as multiple elements or that multiple elements may be designed as one element. In some examples, an element shown as an internal component of one element may be implemented as an external component in another, and vice versa. Furthermore, elements may not be drawn to scale. Non-limiting and non-exhaustive descriptions are described with reference to the following drawings. The components in the figures are not necessarily to scale, emphasis instead being placed upon illustrating principles.
Figure 1A and 1B provide integrated circuits in accordance with specific embodiments of the inventions disclosed herein.
Figure 2 provides a cross section of an integrated circuit on a substrate in accordance with specific embodiments of the inventions disclosed herein.
Figures 3 through 6 provide conceptual diagrams of pitch modifications in accordance with specific embodiments of the inventions disclosed herein.
Figures 7A and 7B provide intellectual property (IP) blocks in accordance with specific embodiments of the inventions disclosed herein.
Figure 8 provides a die-to-die (D2D) connection in accordance with specific embodiments of the inventions disclosed herein.
Figures 9 and 10 provide methods for packaging an integrated circuit in accordance with specific embodiments of the inventions disclosed herein.

### DETAILED DESCRIPTION

Reference will now be made in detail to implementations and embodiments of various aspects and variations of systems and methods described herein. Although several exemplary variations of the systems and methods are described herein, other variations of the systems and methods may include aspects of the systems and methods described herein combined in any suitable manner having combinations of all or some of the aspects described.

Integrated circuit packages with top metal pad pitch adjustments and associated methods in accordance with the summary above are disclosed in detail herein. The methods and systems disclosed in this section are nonlimiting embodiments of the invention, are provided for explanatory purposes only, and should not be used to constrict the full scope of the invention. It is to be understood that the disclosed embodiments may or may not overlap with each other. Thus, part of one embodiment, or specific embodiments thereof, may or may not fall within the ambit of another, or specific embodiments thereof, and vice versa. Different embodiments from different aspects may be combined or practiced separately. Many different combinations and sub-combinations of the representative embodiments shown within the broad framework of this invention, that may be apparent to those skilled in the art but not explicitly shown or described, should not be construed as precluded.

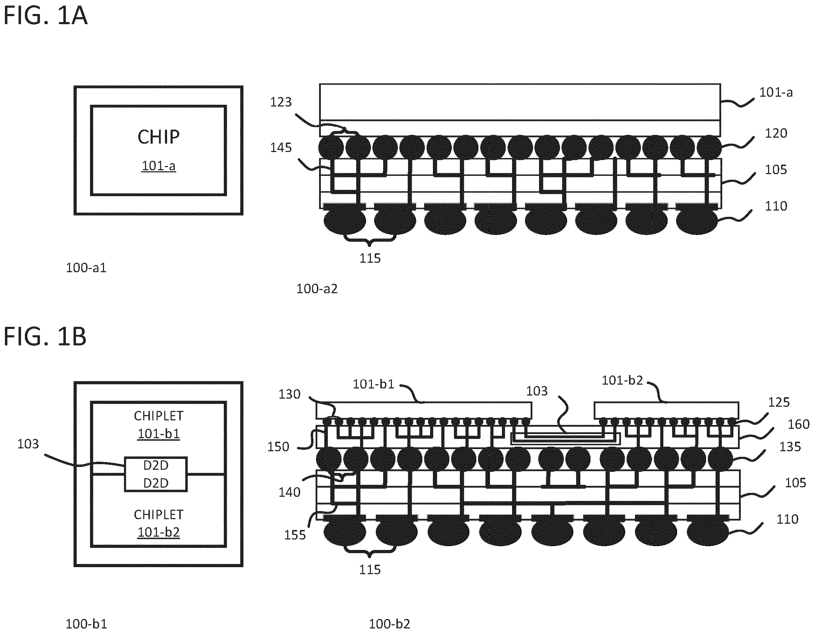

Fig. 1 illustrates packaged integrated circuits. The packaged integrated circuits may be chiplets or traditional chips. View 100-a1 of Figure 1A contains a chip 101-a. View 100-a1 provides a top view of a packaged integrated circuit and view 100-a2 is a side-sliced view of a packaged integrated circuit. Single chip 101-a is connected to an external system.

View 100-b1 of Fig. 1B contains two chiplets 101-b1 and 101-b2. View 100-b1 is a top view of a packaged integrated circuit and view 100-b2 is a side-sliced view of a packaged integrated circuit. In Fig. 1B, the two chiplets 101-b1 and 101-b2 are connected an identical external system, as is chip 101-a, through an interposer 160. The chiplets may be connected to (e.g., may be able to communicate with) each other via a die-to-die (D2D) connection 103.

The external system, or substrate 105, has connections 110 (e.g., copper pillar bump connections) at a pitch 115. In some examples, the pitch 115 may be 110 microns. The chip 101-a has external connections 120 at a pitch 123. The chiplets 101-b have external connections 125 (e.g., bump connections). In some examples, the pitch 130 associated with the connections 125 may be 55 microns. The interposer 160 has connections 135 with a pitch 140. In some examples, the pitch 140 may be between pitch 130 (e.g., 55 microns) and pitch 115 (e.g., 110 microns).

External connections 120 may be coupled with external connections 110 via conductors 145 (e.g., metal wiring monolithically fabricated with the internal connections). In some examples only a subset of internal connections 120 may be coupled with a subset of external connections 110.

External connections 125 may be coupled with connections 135 via conductors 150 (e.g., metal wiring monolithically fabricated with the internal connections). In some examples only a subset of internal connections 125 may be coupled with a subset of connections 135. Connections 135 may be coupled with external connection 110 via conductors 155 (e.g., metal wiring monolithically fabricated with the internal connections). In some examples only a subset of connections 135 may be coupled with a subset of external connections 110.

The external connections may be external contacts such as pads, solder balls, bumps, pillars, leads, or other conductive connections. The integrated circuits in Fig. 1A and Fig. 1B may be connected to one or more substrates as part of the process of packaging the integrated circuits. The integrated circuits may be commonly connected to a substrate with other chips or chiplets as part of the process of packaging the integrated circuits. The substrate may be an organic substrate. Substrate 105 can be the substrate of various package types. The integrated circuits may be commonly connected to an interposer as part of the process of packaging the integrated circuits. The interposer, such as interposer 160, may include multiple chips and auxiliary devices with both connections to external systems and other devices on the interposer.

The integrated circuits in Fig. 1A and Fig. 1B may have multiple sets of internal connections with different pitches. For example, two chiplets may have similar base circuitry but differ in the pitch of their external connections. This can be referred to as the chiplet pitch of the chiplet. Different chiplet pitches may be fabricated for similar chiplets in order to comply with different packaging restraints.

Some chiplets require a high number of independent connections between the chiplets. For example, the illustrated chiplets 101-b could be computation chiplets that are configured to conduct parallel processing with other chiplets in order to execute a complex computation. The chiplets 101-b may include a large number of external connections on the bottom side of the chiplets 101-b. However, as communication speed between integrated circuits generally, and chiplets conducting parallel processing of complex computations more specifically, is very important, the chiplets 101-b may be designed to have a large number of direct contacts between adjacent chiplets on at least one side of the chiplet. The side of the chiplet that includes this requirement may be referred to as the D2D interface and will provide contacts for the D2D connection 103.

Chiplets, and integrated circuits generally, that are in accordance with specific embodiments of the present invention, may have the same internal connections and different pitches for their external connections. For example, in some examples, a chiplet may have a pitch (e.g., 65 microns) for its internal connections. This pitch may then be kept at 65 microns for the external connections using a first top level metal wiring pattern or be increased (e.g., to 130 microns) using a second top level metal wiring pattern that only connects one out of every other internal connection to the external connections. For example, chiplet 101-a can be essentially the same as chiplet 101-b except that chiplet 101-a has different metal wiring layers between the internal connections to the base layers of the chip and the external connections. Chiplet 101-b can thereby be used in an application which requires a high density of external connections in a D2D interface. This same chiplet, can also be used as chiplet 101-a with a simpler external system that does not need as many connections.

In specific embodiments of the invention, a method of packaging an integrated circuit 100 is provided. The method includes forming a set of devices for the integrated circuit. The devices may be passive or active devices such as logic transistors used in a processor or capacitors or resistors used in an analog circuit. The method may also include forming a set of internal connections of the integrated circuit that are coupled to the set of devices of the integrated circuit. The set of internal connections may be pads of conductive material formed in layers above the devices of the integrated circuit. The set of internal connections may be connected to the devices by vias that are coupled to highly doped regions of the semiconductor material of the integrated circuit. The method may also include selecting a set of masks from a library of sets of masks. The set of masks may define a top-level wiring pattern to be formed on the integrated circuit. The sets of masks in the library of sets of masks may be configured to form different sets of metal wiring layers. The library of sets of masks may be configured to allow a designer to modify an integrated circuit during back-end-of-line processing to allow the integrated circuit to interoperate with packages having different configurations for the external connections of the integrated circuit. The different configurations may be set by the routing pattern of the top-level metal. The method may continue with forming a set of metal wiring layers of the integrated circuit using the set of masks. The different sets of metal wiring layers may differ in how they connect the internal connections of the integrated circuit 100 to the external connections of the integrated circuit 100. The set of metal wiring layers may alter the pitch of the internal connections so that the device may interface with a package having different spacing for the external connections. The method may continue with coupling a set of external connections of the integrated circuit 100 to the set of internal connections via the metal wiring layers.

In specific embodiments of the invention, the set of metal wiring layers leaves a subset of the set of internal connections uncoupled from the set of external connections. The internal connections may still be connected to internal circuit elements, but the pads are left floating from the perspective of the external connection that would otherwise be connected to the pads. In these same embodiments, a different set of metal wiring layers applied to the same underlying integrated circuit 100 may use all the internal connections and couple all of them to a set of external connections. Accordingly, the different sets of metal wiring layers that may be used with a given integrated circuit 100 and that are associated with different sets of masks may differ in how many of the internal connections in the set of internal connections are uncoupled from the set of external connections.

By changing the masks for the formation of the conductors (e.g., metal wires) between internal and external connections, a chiplet may be more easily adapted to different packaging requirements. For example, the main circuitry (e.g., including devices such as transistors) can be maintained while only top layers of the chiplet are adjusted for packaging purposes. Different wire stacks may be used. Post-tapeout changes may be enabled. The top layer changes may be relatively inexpensive, and the time from inventory through final processing may be reduced compared to conventional methods. Selecting the masks for metal wiring based on packaging requirements enables a configurable package design.

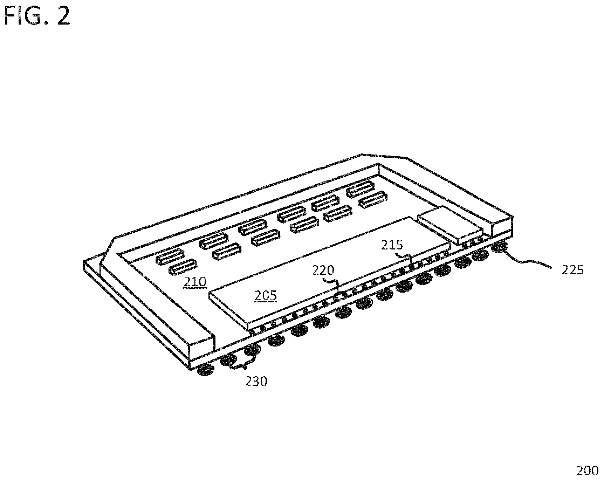

Fig. 2 illustrates a packaged device 200 in the form of a chiplet 205 being placed on a substrate 210. Substrate 210 may be an organic substrate. Substrate 210 can be the substrate of a package. The chiplet 205 has external connections 215 with a pitch 220. In some examples, the pitch 220 may be 130 microns. Substrate 210 may include connections 225 with a pitch 230. The pitch 230 may be different than the pitch 220. The chiplet 205 may be connected to the substrate 210 via solder balls that cover a bottom surface of the chiplet and that have a pitch 220 of 130 microns. What is shown here is one embodiment of how a chiplet may be connected to a substrate (e.g., an organic substrate). There are alternative methods of connecting chiplets to a substrate using different pitches or different connection types.

In specific embodiments of the invention, the packaged device 200 may include internal connections 215 of the integrated circuit that are coupled to a set of devices of the integrated circuit 200. The set of devices may be logic transistors. For example, in situations in which the integrated circuit 200 is a processor, the devices may form the computational units of the processor. The internal connections may be pads in the integrated circuit within chiplet 205. For example, they could be flat areas of metal that are formed to provide contacts to higher metal layers by way of vias or other conductive connections during fabrication of the integrated circuit.

The internal connections (e.g., in the integrated circuit within chiplet 205) may have various configurations. For example, the internal connections (e.g., connections 215) could be formed along a periphery of the integrated circuit in a band that frames the integrated circuit. Alternatively, the internal connections may be found over an entire top or bottom surface of the integrated circuit. In the case of the internal connections being formed over the bottom surface of the integrated circuit through semiconductor, vias may be used to couple the devices to the internal connections. The internal connections (e.g., connections 215) may have a pitch (e.g., pitch 220) that is set by the processing requirements of the integrated circuit and the size of the internal connections required by the metal wiring layers disclosed herein. The pitch of the internal connections may be referred to as the first pitch of the overall structure that is packaged device 200. The internal connections may be laid out in a regular rectangular array, checkerboard, or other pattern on one or more layers of the integrated circuit within chiplet 205.

In specific embodiments of the invention, an integrated circuit may include external connections that are coupled to the internal connections via a set of wiring layers. The external connections may be formed from higher level metal layers of the integrated circuit. The term "higher" is used herein to refer to layers that are formed after others regardless of the relative position of the layers to each other. For example, in a flip chip configuration, the metal wiring may be below the devices of the original device from the perspective of the devices as they were originally fabricated. However, the metal wiring layers are still formed subsequent to the device layers and may therefore be referred to as "higher" layers. The external connections may have a second pitch that is different than the first pitch. The first pitch and the second pitch may differ by any factor such as by a factor of two or more. For example, the first pitch may be 65 microns and the second pitch may be 130 microns. In specific embodiments of the invention, the integrated circuits may include, or be put into packages that include, a second set of external connections in addition to the first set of external connections. The second set of external connections may have a third pitch. The metal wiring may connect the internal connections to both the first set of external connections and the second set of external connections.

In specific embodiments, a given circuit design may be capable of being paired with different sets of metal wiring layers to form different completed chips. The different sets of metal wiring layers may be selected to couple the internal connections of the integrated circuit with external connections having different connections and different pitches. The pitches of the external connections may be different than that of the internal connections and may also vary across a given integrated circuit. The different sets of metal wiring layers allow a given integrated circuit design to be paired with different packages. The decision to pair the integrated circuit with a given package having a certain pitch may be determined during back end of line processing for the integrated circuit when the top-level metal wiring layers of the integrated circuit are being formed. The term "sets" of metal wiring layers is used herein because the wires are likely to extend through multiple layers to allow for routing complex connection patterns where one route may duck under or go over another. However, in specific embodiments of the invention, the sets of metal wiring layers may be a set of one layer. These sets of metal wiring layers may likewise be formed by sets of masks, using standard lithography or similar approaches, where the set of masks may include a single mask in the case of a single layer of wiring.

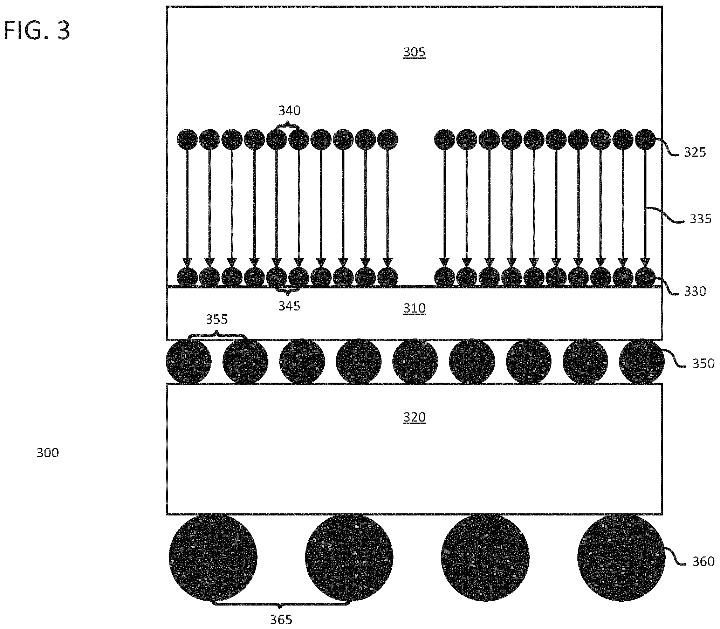

Figs. 3 through 6 present conceptual diagrams of pitch modifications from internal connections to substrate ball grid array connections. Figs. 3 through 6 may be fabricated using different sets of masks. Fig. 3 shows an example of connections between an integrated circuit and external connections. The packaged device 300 includes silicon 305, a redistribution layer 310, and a substrate 320 (e.g., an organic substrate of a package). The silicon may house internal connections 325 and external connections 330 coupled together via conductors 335 (e.g., metal wiring monolithically fabricated with the internal connections). In some examples, a subset of connections 325 may be coupled to a subset of connections 330. Connections 325 may have a pitch 340 and connections 330 may have a pitch 345. In some examples, pitch 340 may be the same as pitch 345. In other examples, pitch 340 may be different than pitch 345. The redistribution layer 310 may include connections 350 with a pitch 355. Redistribution layer 310 may be an interposer. The pitch 355 may be different than pitch 345. The substrate 320 may include connections 360 with a pitch 365. Substrate 320 may be the substrate of a package. The pitch 365 may be different than pitch 355.

In Fig. 3, the lowest layer of connections on the page are the internal connections 325 (e.g., 65 micron pitch pads in metal layer), the next lowest level are the external connections 330 (e.g., 65 micron pitch bump metal for the integrated circuit), the next level is connections 350 (e.g., 150 micron pitch bump metal) in the redistribution layer 310, the highest level is connections 360 (e.g., ball grid array contacts) for a substrate 320 (e.g., organic substrate) of a package. The internal connections may connect to the semiconductor layer of the integrated circuit (e.g., connect to the terminals of passive devices or transistors formed in the semiconductor layer).

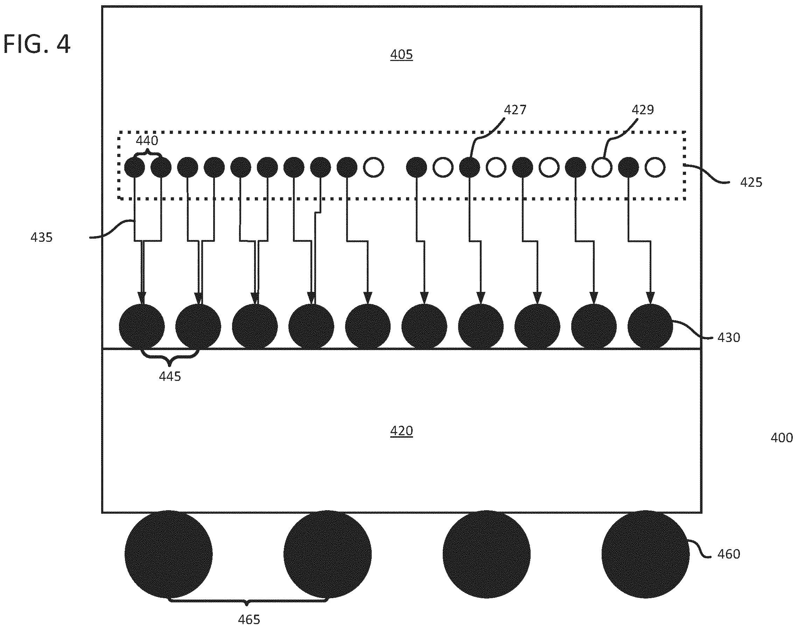

Fig. 4 shows an example of connections between an integrated circuit and external connections. The packaged device 400 includes silicon 405 and a substrate 420 (e.g., an organic substrate) of a package. The silicon may house internal connections 425 and external connections 430 coupled together via conductors 435 (e.g., metal wiring monolithically fabricated with the internal connections). In some examples, a subset 427 of connections 425 may be coupled to a subset of connections 430. Another subset 429 of connections 425 may refrain from being coupled to connections 430. Connections 425 may have a pitch 440 and connections 430 may have a pitch 445. Pitch 440 may be different than pitch 445. Substrate 420 may include connections 460 with a pitch 465. The pitch 465 may be different than pitch 445.

In Fig. 4, the external connections 430 have the same pitch as the external connections 350 mentioned above (e.g., 130-micron pitch bump metal for the integrated circuit). As seen from a comparison of Fig. 3 and Fig. 4, the same integrated circuit may be used with different external connections and be made compatible with different external systems by changing the top-level wiring layers of the integrated circuit. Fig. 4 also illustrates how multiple internal connections 425 may be coupled to the same external connection 430 (i.e., multiple 65-micron pitch metal layer pads connected to the same 130-micron pitch package bumps). For example, power or ground traces could be routed to multiple internal connections 425 from a single external connection 430.

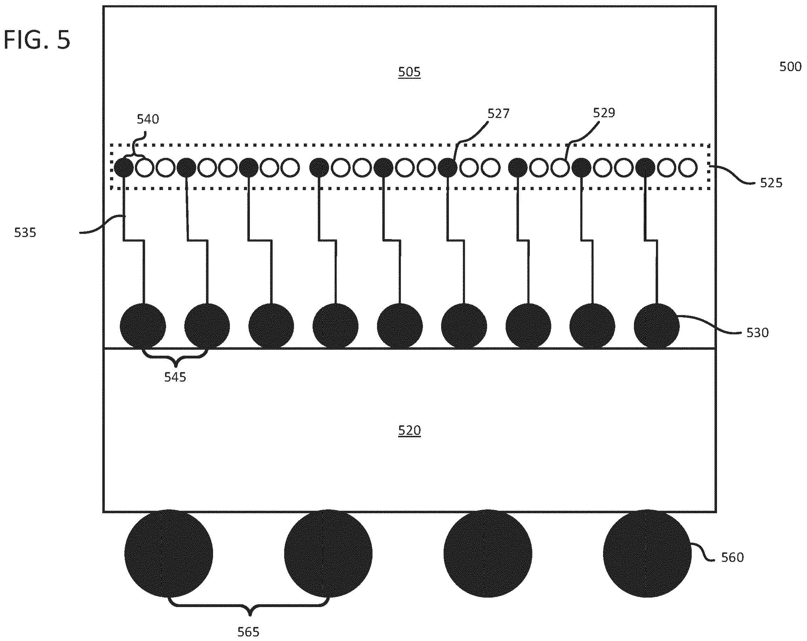

The pitch 440 of the internal connections 425 may vary from one integrated circuit to the next. For example, in Fig. 5, the internal connections are metal layer pads which have a pitch of 45 microns in contrast to the metal layer pads of Figs. 3 and 4 which have a pitch of 65 microns.

Fig. 5 shows an example of connections between an integrated circuit and external connections. The packaged device 500 includes silicon 505 and a substrate 520 (e.g., an organic substrate) of a package. The silicon may house internal connections 525 and external connections 530 coupled together via conductors 535 (e.g., metal wiring monolithically fabricated with the internal connections). In some examples, a subset 527 of connections 525 may be coupled to a subset of connections 530. Another subset 529 of connections 530 may refrain from being coupled to connections 530. Subset 527 and subset 529 may be organized such that, when moving along a row of connections 525, the portions of subset 527 and portions of subset 529 alternate. For example, every third connection 525 may belong to subset 527 (as depicted). Alternatively, every other connection 525 may belong to subset 527. The quantity of connections 525 in subset 527 may or may not be the same as the quantity of connections 525 in subset 529. In some examples, there may not be a specific patterned relationship between subset 527 and subset 529. Connections 525 may have pitch 540 and connections 530 may have a pitch 545. Pitch 540 may be different than pitch 545. Substrate 520 may include connections 560 with a pitch 565. The pitch 565 may be different than pitch 545.

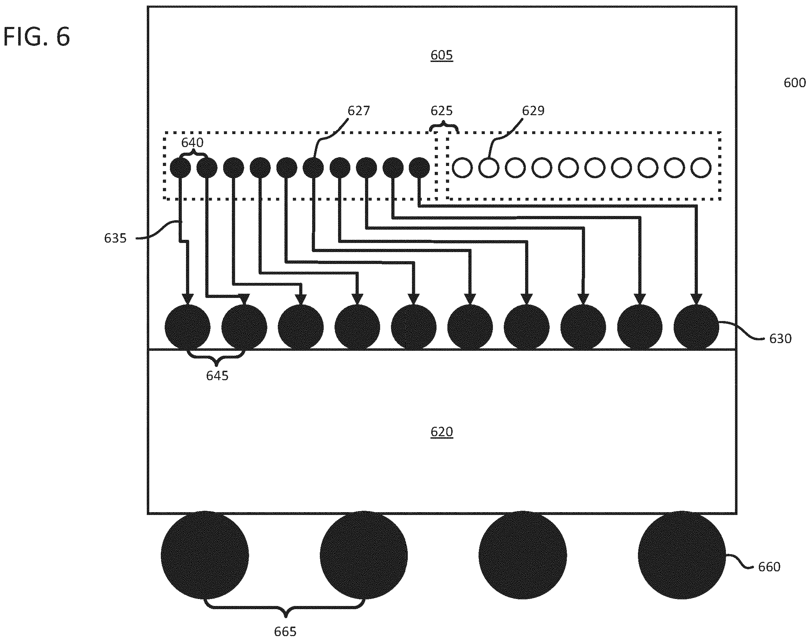

Fig. 6 shows an example of connections between an integrated circuit and external connections. The packaged device 600 includes silicon 605 and a substrate 620 (e.g., an organic substrate) of a package. The silicon may house internal connections 625 and external connections 630 coupled together via conductors 635 (e.g., metal wiring monolithically fabricated with the internal connections). In some examples, a subset 627 of connections 625 may be coupled to a subset of connections 630. Another subset 629 of connections 630 may refrain from being coupled to connections 630. Subset 627 and subset 629 may be organized such that, when moving along a row of connections 625, the entire subset 627 is first, then the entire subset 629 follows. Connections 625 may have pitch 640 and connections 630 may have a pitch 645. Pitch 640 may be different than pitch 645. Substrate 620 may include connections 660 with a pitch 665. Pitch 665 may be different than pitch 645.

In specific embodiments, the set of external connections are provided to connect the integrated circuit with a package for the integrated circuit. For example, in Figs. 3 and 4, the external connections may be solder bumps formed on a chiplet package. In specific embodiments, the set of metal wiring layers form a set of conductive pathways that couple to the external connections and a pitch of the set of conductive pathways is equal to a pitch of the external connections to the package. Fig. 3 above is in accordance with these embodiments. In specific embodiments, the set of metal wiring layers form a set of conductive pathways that couple to the external connections and a pitch of the set of conductive pathways is not equal to a pitch of the external connections on the package. Fig. 4 above is in accordance with these embodiments.

In specific embodiments of the invention, an integrated circuit is provided. The integrated circuit comprises a set of devices, and a set of internal connections that are coupled to the set of devices and that have a first pitch. The set of internal connections may be a set of metal layer pads. The integrated circuit also comprises a set of external connections that are coupled to the set of internal connections and that have a second pitch, and a set of metal wiring layers of the integrated circuit that couple the set of internal connections to the set of external connections. A subset of the set of internal connections are not connected to the set of external connections. Fig. 4 is in accordance with these embodiments. In specific embodiments, the subset of the set of internal connections are not connected to any of the metal wiring layers in the set of metal wiring layers. The set of external connections may be package contacts such as solder balls, bumps, pillars, or leads that are formed on a package for the integrated circuit.

In specific embodiments, the integrated circuit may also comprise a second set of external connections having a third pitch. The set of metal wiring layers of the integrated circuit may couple the set of internal connections to the second set of external connections. The pitch of the different sets of external connections may be different and the same wiring layers may connect the internal connections to both sets. In specific embodiments, the set of internal connections cover a periphery of the integrated circuit. For example, a set of metal layer pads may be formed all around the edges of the integrated circuit. The sets of external connections may be on different sides of the integrated circuit. In these embodiments, the integrated circuit could be configured to couple with an external system having a first pitch on one side, or on part of one side, and another external system having a different pitch on another side.

In specific embodiments, the underlying circuity (i.e., the circuity below the internal connections and metal layers that allow for the pitch adjustment disclosed herein) may be an IP block that is configured, using the approaches disclosed herein, to interface with different bump pitches. In this way, a single circuit design for an IP block may be bundled with different bump pitches without the need for a circuit redesign when the bump pitch of the IP block changes.

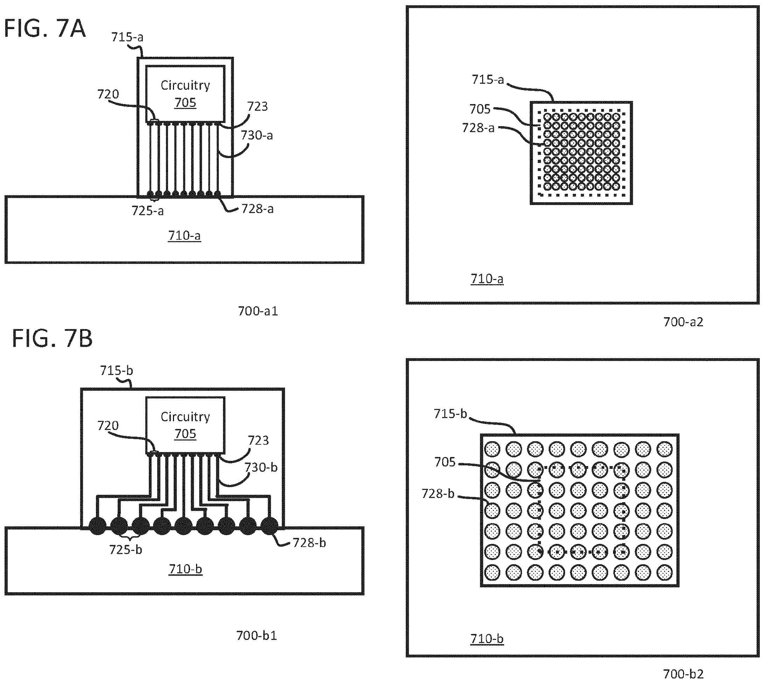

An example of this approach is shown in Fig. 7 which shows how a single IP block may be made to interface with packages having three different bump pitches. Circuit system 700-a includes a side view (view 700-a1) and top view (view 700-a2). Circuit system 700-b includes a side view (view 700-b1) and top view (view 700-b2). The IP blocks 715 house circuitry 705. The circuitry 705 may be the same between the two IP blocks 715-a and 715-b. Blocks 710 may be substrates or interposers. Connections 723 have pitches 720, which may be the same between circuit systems 700-a and 700-b. The connections 728-a and 728-b may have pitches 725-a and 725-b respectively. The pitches 725-a and 725-b may be different between circuit systems 700-a and 700-b. Connections 723 may be coupled with connections 728-a via conductors 730-a (e.g., sets of metal wires). Connections 723 may be coupled with connections 728-b via conductors 730-b (e.g., sets of metal wires) with a different layout or configuration than conductors 730-a.

In one example, the pitches for the connections (e.g., packages) are 45 microns for pitch 720 and pitch 725-a and 110 microns for pitch 725-b, although different pitch values are possible. In circuit systems 700-a and 700-b, a top view is shown to illustrate how the same circuitry 705 within an IP block 715-a or 715-b is utilized in either case and only the distribution of the conductors 730 (e.g., lines) out from the internal connections to the external connections needs to be modified.

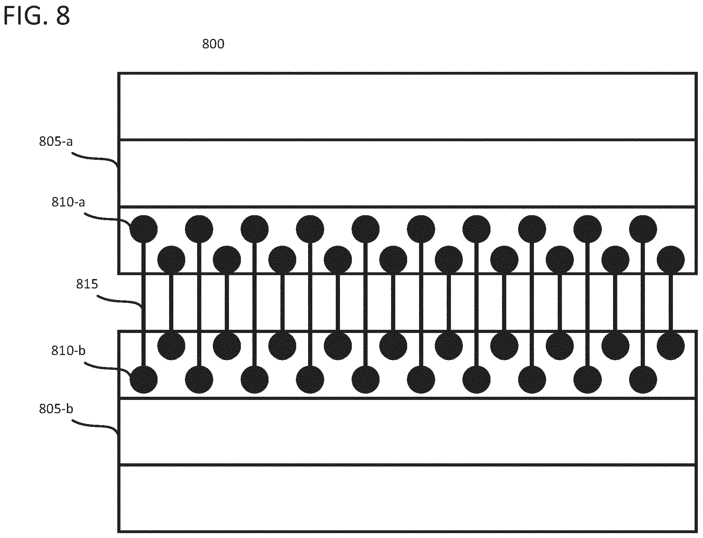

Fig. 8 provides an example of a D2D connection 800 in accordance with specific embodiments of the inventions disclosed herein. Chiplets 805-a and 805-b include connections 810-a and 810-b respectively. Connections 810-a and 810-b are coupled together via conductors 815 (e.g., metal traces on a substrate or an interposer). The chiplets can both be produced using the approaches disclosed herein and include a fine pitch for maximizing the number of connections available for die-to-die communication. Importantly, each of the chiplets can be designed for communication with alternative chiplets having specific interconnect pitches without having to reserve space for alternative pitch connections at the D2D interface. For example, in approaches which do not utilize specific embodiments of the inventions disclosed herein, half of the illustrated D2D interface might need to be reserved for connection with a die that used a different contact pitch. Accordingly, specific embodiments of the inventions disclosed herein allow for maximizing the amount of connections that can be provided in a D2D interface of a chiplet system, which will tend to have a high density of required connections, by adjusting the top metal layers of the chip for a desired pitch density across the entire D2D interface.

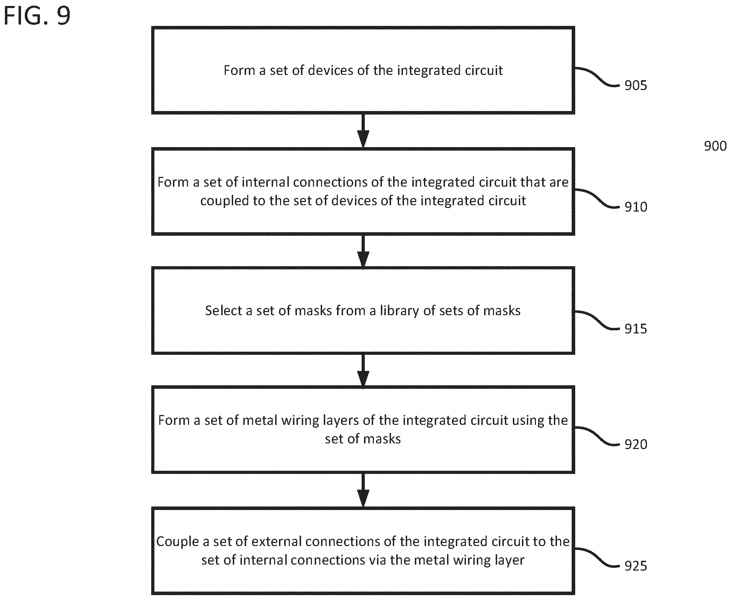

Fig. 9 provides a method 900 for packaging an integrated circuit. At 905, a set of devices of the integrated circuit are formed. The devices may be transistors, capacitors, or other devices or a combination of devices. At 910, a set of internal connections of the integrated circuit are coupled to the set of devices of the integrated circuit. At 915, a set of masks from a library of sets of masks is selected. The sets of masks in the library of sets of masks are configured to form different sets of metal wiring layers. At 920, a set of metal wiring layers of the integrated circuit are formed using the set of masks selected at 915. The different sets of metal wiring layers differ in how they connect the internal connections of the integrated circuit to the external connections of the integrated circuit. At 925, a set of external connections of the integrated circuit are coupled to the set of internal connections via the metal wiring layer formed at 920.

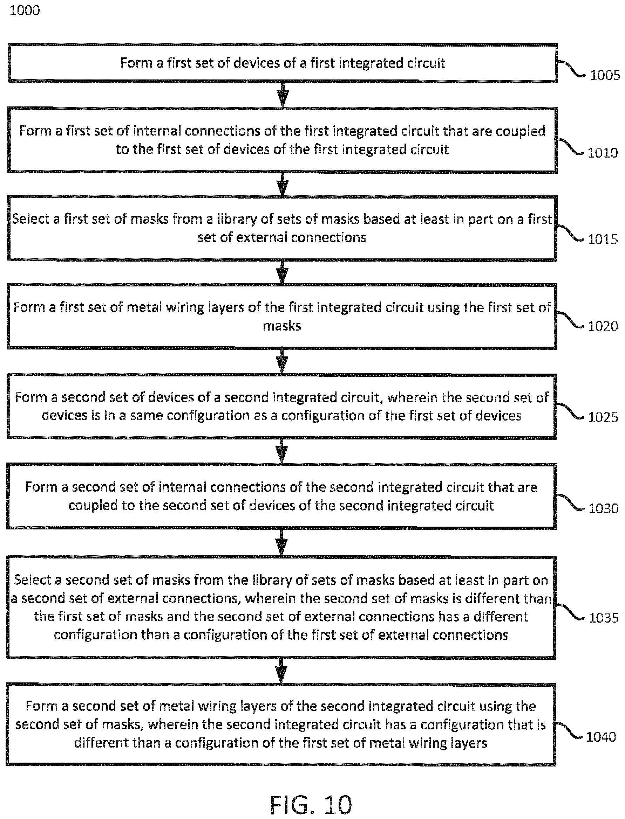

Fig. 10 provides a method 1000 for packaging an integrated circuit. At 1005, a first set of devices of the integrated circuit are formed. The devices may be transistors, capacitors, or other devices or a combination of devices. At 1010, a first set of internal connections of the first integrated circuit is formed. The first set of internal connections are coupled to the first set of devices of the first integrated circuit. At 1015, a first set of masks from a library of sets of masks is selected based at least in part on a first set of external connections. At 1020, a first set of metal wiring layers of the first integrated circuit is formed using the first set of masks selected at 1015. At 1025, a second set of devices of a second integrated circuit is formed. The second set of devices may be in a same configuration as a configuration of the first set of devices. At 1030, a second set of internal connections of the second integrated circuit is formed. The second set of internal connections are coupled to the second set of devices of the second integrated circuit. At 1035, a second set of masks from the library of sets of masks is selected based at least in part on a second set of external connections. The second set of masks may be different than the first set of masks. The second set of external connections has a different configuration than a configuration of the first set of external connections. At 1040, a second set of metal wiring layers of the second integrated circuit is formed using the second set of masks, wherein the second integrated circuit has a configuration that may be different than a configuration of the first set of metal wiring layers.

Other aspects of the invention are defined in the following numbered statements:
Statement 1. A method of packaging an integrated circuit comprising:
   forming a set of devices of the integrated circuit;
   forming a set of internal connections of the integrated circuit that are coupled to the set of devices of the integrated circuit;
   selecting a set of masks from a library of sets of masks;
   forming a set of metal wiring layers of the integrated circuit using the set of masks; and
   coupling a set of external connections of the integrated circuit to the set of internal connections via the metal wiring layers;
   wherein: (i) the sets of masks in the library of sets of masks are configured to form different sets of metal wiring layers; and (ii) the different sets of metal wiring layers differ in how they connect the internal connections of the integrated circuit to the external connections of the integrated circuit.
Statement 2. The method of Statement 1, wherein:
   the set of metal wiring layers leaves a subset of the set of internal connections uncoupled from the set of external connections; and
   the different sets of metal wiring layers differ in how many of the internal connections in the set of internal connections are uncoupled from the set of external connections.
Statement 3. The method of Statement 1 or 2, wherein:
   the set of external connections are provided as part of a package for the integrated circuit.
Statement 4. The method of Statement 3, wherein:
   the set of metal wiring layers form a set of leads that couple to the external connections; and
   a pitch of the set of leads is equal to a pitch of the external connections on the package.
Statement 5. An integrated circuit comprising:
   a set of devices;
   a set of internal connections that are coupled to the set of devices and that have a first pitch, wherein the set of internal connections are a set of metal layer pads;
   a set of external connections that are coupled to the set of internal connections and that have a second pitch; and
   a set of metal wiring layers of the integrated circuit that couple the set of internal connections to the set of external connections;
   wherein a subset of the set of internal connections are not connected to the set of external connections.
Statement 6. The integrated circuit of Statement 5, wherein:
   the subset of the set of internal connections are not connected to any of the metal wiring layers in the set of metal wiring layers.
Statement 7. The integrated circuit of Statement 5 or 6, wherein:
   the set of external connections are package contacts.
Statement 8. The integrated circuit of any of Statements 5 to 7, wherein:
   the set of external connections are one of solder balls, bumps, pillars, leads.
Statement 9. The integrated circuit of any of Statements 5 to 8, further comprising:
   a second set of external connections having a third pitch, wherein the set of metal wiring layers of the integrated circuit couple the set of internal connections to the second set of external connections.
Statement 10. The integrated circuit of Statement 9, further comprising:
   the set of internal connections cover a periphery of the integrated circuit;
   the set of external connections is on a first side of the integrated circuit; and
   the second set of external connections is on a second side of the integrated circuit.
Statement 11. The integrated circuit of any of Statements 5 to 10, wherein:
   the integrated circuit is a chiplet;
   the set of devices are transistors; and
   the first pitch and the second pitch differ by a factor of two or more.

While the specification has been described in detail with respect to specific embodiments of the invention, it will be appreciated that those skilled in the art, upon attaining an understanding of the foregoing, may readily conceive of alterations to, variations of, and equivalents to these embodiments. For example, while the specification referred to chiplets, any form of integrated circuit can be used in place of the chiplets in these examples in accordance with the approaches disclosed herein. As another example, while integrated circuits were referred to in examples herein as being composed of silicon, the teaching disclosed herein are more broadly applicable to any integrated circuit including those made by other semiconductor materials such as silicon carbide and gallium nitride. These and other modifications and variations to the present invention may be practiced by those skilled in the art, without departing from the scope of the present invention, which is more particularly set forth in the appended claims.

## Claims

1. A method of packaging an integrated circuit comprising:
forming a set of devices of the integrated circuit;
forming a set of internal connections of the integrated circuit that are coupled to the set of devices of the integrated circuit;
selecting a set of masks from a library of sets of masks;
forming a set of metal wiring layers of the integrated circuit using the set of masks; and
coupling a set of external connections of the integrated circuit to the set of internal connections via the metal wiring layers;
wherein: (i) the sets of masks in the library of sets of masks are configured to form different sets of metal wiring layers; and (ii) the different sets of metal wiring layers differ in how they connect the internal connections of the integrated circuit to the external connections of the integrated circuit.

2. The method of claim 1, wherein:
the set of metal wiring layers leaves a subset of the set of internal connections uncoupled from the set of external connections; and
the different sets of metal wiring layers differ in how many of the internal connections in the set of internal connections are uncoupled from the set of external connections.

3. The method of claim 1 or 2, wherein:
the set of external connections are provided as part of a package for the integrated circuit.

4. The method of claim 3, wherein:
the set of metal wiring layers form a set of leads that couple to the external connections; and
a pitch of the set of leads is equal to a pitch of the external connections on the package.

5. An integrated circuit comprising:
a set of devices;
a set of internal connections that are coupled to the set of devices and that have a first pitch, wherein the set of internal connections are a set of metal layer pads;
a set of external connections that are coupled to the set of internal connections and that have a second pitch; and
a set of metal wiring layers of the integrated circuit that couple the set of internal connections to the set of external connections;
wherein a subset of the set of internal connections are not connected to the set of external connections.

6. The integrated circuit of claim 5, wherein:
the subset of the set of internal connections are not connected to any of the metal wiring layers in the set of metal wiring layers.

7. The integrated circuit of claim 5 or 6, wherein:
the set of external connections are package contacts.

8. The integrated circuit of any of claims 5 to 7, wherein:
the set of external connections are one of solder balls, bumps, pillars, leads.

9. The integrated circuit of any of claims 5 to 8, further comprising:
a second set of external connections having a third pitch, wherein the set of metal wiring layers of the integrated circuit couple the set of internal connections to the second set of external connections.

10. The integrated circuit of claim 9, further comprising:
the set of internal connections cover a periphery of the integrated circuit;
the set of external connections is on a first side of the integrated circuit; and
the second set of external connections is on a second side of the integrated circuit.

11. The integrated circuit of any of claims 5 to 10, wherein:
the integrated circuit is a chiplet;
the set of devices are transistors; and
the first pitch and the second pitch differ by a factor of two or more.

12. A method comprising:
forming a first set of devices of a first integrated circuit;
forming a first set of internal connections of the first integrated circuit that are coupled to the first set of devices of the first integrated circuit;
selecting a first set of masks from a library of sets of masks based at least in part on a first set of external connections;
forming a first set of metal wiring layers of the first integrated circuit using the first set of masks;
forming a second set of devices of a second integrated circuit, wherein the second set of devices is in a same configuration as a configuration of the first set of devices;
forming a second set of internal connections of the second integrated circuit that are coupled to the second set of devices of the second integrated circuit;
selecting a second set of masks from the library of sets of masks based at least in part on a second set of external connections, wherein the second set of masks is different than the first set of masks and the second set of external connections has a different configuration than a configuration of the first set of external connections; and
forming a second set of metal wiring layers of the second integrated circuit using the second set of masks, wherein the second integrated circuit has a configuration that is different than a configuration of the first set of metal wiring layers.

13. The method of claim 12, further comprising:
coupling the first set of external connections of the first integrated circuit to the first set of internal connections via the first set of metal wiring layers; and
coupling the second set of external connections of the second integrated circuit to the second set of internal connections via the second set of metal wiring layers.

14. The method of claim 12 or 13, wherein forming the first set of metal wiring layers comprises leaving a subset of the first set of internal connections uncoupled from the first set of external connections in a first metal wiring configuration.

15. The method of claim 14, wherein forming the second set of metal wiring layers comprises leaving a subset of the second set of internal connections uncoupled from the second set of external connections in a second metal wiring configuration, a quantity of the subset of the first set of internal connections uncoupled from the first set of external connections being different than a quantity of the subset of the second set of internal connections uncoupled from the second set of external connections.

16. The method of any of claims 12 to 15, wherein:
the first set of external connections is associated with a first package; and
the second set of external connections is associated with a second package.

17. The method of claim 16, wherein:
the first package is different than the second package.

18. The method of any of claims 12 to 17, wherein:
the first set of external connections are one of solder balls, bumps, pillars, leads; and
the second set of external connections are one of solder balls, bumps, pillars, leads.

19. The method of any of claims 12 to 18, wherein:
the first and second integrated circuits are chiplets; and
the first and second sets of devices are transistors.

20. The method of any of claims 12 to 19, wherein:
the first set of internal connections are associated with a first pitch, the second set of internal connections are associated with a second pitch, the first set of external connections are associated with a third pitch, and the second set of external connections are associated with a fourth pitch;
the first pitch is different than the third pitch;
the second pitch is different than the fourth pitch; and
the third pitch is different than the fourth pitch.
